# EUROPÄISCHE PATENTSCHRIFT

(11) **EP 3 597 015 B1**
(45) Veröffentlichungstag und Bekanntmachung des Hinweises auf die Patenterteilung: **05.05.2021**
(21) Anmeldenummer: 18711542.3
(22) Anmeldetag: 14.03.2018
(51) Int. Cl.: H05H 1/24

(54) **PLASMAGENERATOR**
PLASMA GENERATOR
GÉNÉRATEUR DE PLASMA

(30) Priorität: 14.03.2017 DE 102017105410
(43) Veröffentlichungstag der Anmeldung: 22.01.2020
(73) Patentinhaber: TDK Electronics AG, 81671 München (DE); Relyon Plasma GmbH, 93055 Regensburg (DE)
(72) Erfinder: NETTESHEIM, Stefan, 93051 Regensburg (DE); BURGER, Dominik, 93087 Alteglofsheim (DE); HOPPENTHALER, Florian, 94365 Parkstetten (DE); WEILGUNI, Michael, 4232 Hagenberg (AT); PUFF, Markus, Graz 8010 (AT); KUDELA, Pavol, 8530 Deutschlandsberg (AT)
(74) Vertreter: Epping - Hermann - Fischer
(86) Internationale Anmeldenummer: PCT/EP2018/056418
(87) Internationale Veröffentlichungsnummer: WO 2018/167159

(56) Entgegenhaltungen:
- DE-A1-102014 110 405
- DE-A1-102015 112 410
- US-A1- 2010 042 094

## Beschreibung

Die vorliegende Erfindung betrifft einen Plasmagenerator zur Erzeugung von nichtthermischem Atmosphärendruck-Plasma.

Ein solcher Plasmagenerator kann insbesondere einen piezoelektrischen Transformator aufweisen, der eine Bauform eines Resonanztransformators ist, welcher auf Piezoelektrizität basiert und im Gegensatz zu den herkömmlichen magnetischen Transformatoren ein elektromechanisches System darstellt. Bei dem piezoelektrischen Transformator kann es sich insbesondere um einen Rosen-Transformator handeln.

Wird ein piezoelektrischer Transformator zur Erzeugung eines nichtthermischen Atmosphärendruck-Plasmas verwendet, so wird in seinem Ausgangsbereich eine Hochspannung erzeugt. Wird der piezoelektrische Transformator in einem Gas als Last betrieben, so kann es vorkommen, dass gelegentlich an längsseitigen Kanten entlang des Ausgangsbereichs ein Plasma gezündet wird. Der Grund dafür ist, dass sich das maximale Potential bei Vorhandensein einer kapazitiven Last am Ausgang nicht am Ausgang selbst, sondern, je nach Last und Bauteilgeometrie, einige Millimeter vom Ausgang entfernt einstellt. Die Wahrscheinlichkeit, dass es dadurch zum Zünden entlang der Kanten kommt, ist zwar gering, kann aber nicht gänzlich ausgeschlossen werden. Kommt es zu einem wiederholten Zünden an einer der Kanten, so findet diese Zündung in der Regel am selben Punkt wie zuvor statt. Es reicht aus, dass das Bauteil an diesem Punkt einige wenige Male Plasma zündet, um dort Risse beziehungsweise in weiterer Folge Brüche hervorzurufen.

Um unerwünschte Plasmazündungen an den längsseitigen Kanten des Ausgangsbereichs zu vermeiden, sind zusätzliche Maßnahmen erforderlich. DE 10 2014 110 405 A1 beschreibt beispielsweise, dass die ausgangsseitigen längsseitigen Kanten abgerundet werden können oder dass der Ausgangsbereich zumindest teilweise von einer Isolierung umgeben werden könnte, um die unerwünschten Plasmazündungen entlang der Kanten zu vermeiden. Insbesondere durch die teilweise Isolierung des Ausgangsbereichs werden Schwingungen des piezoelektrischen Transformators gedämpft, so dass der Wirkungsgrad der Plasmaerzeugung reduziert wird. Ferner stellt die Isolierung einen die Lebensdauer des Transformators reduzierenden Faktor da. Das Abrunden der Kanten erfordert zusätzliche Fertigungsschritte, die den Fertigungsaufwand erhöhen.

Aufgabe der vorliegenden Erfindung ist es nunmehr, einen vereinfachten Plasmagenerator anzugeben, bei dem beispielsweise auf derartige Maßnahmen zur Modifikation des piezoelektrischen Transformators verzichtet werden kann.

Die Aufgabe wird durch den Gegenstand des vorliegenden Anspruchs 1 gelöst.

Es wird ein Plasmagenerator zur Erzeugung von nichtthermischem Atmosphärendruck-Plasma vorgeschlagen, der einen piezoelektrischen Transformator, der in Längsrichtung in einen Eingangsbereich und einen Ausgangsbereich unterteilt ist, aufweist. Der piezoelektrische Transformator weist eine ausgangsseitige Stirnseite auf, die vom Eingangsbereich weg weist. Der Plasmagenerator ist derart ausgestaltet, dass nur dann eine zur Zündung eines nichtthermischen Atmosphärendruck-Plasmas ausreichende Leistung an den Eingangsbereich des piezoelektrischen Transformators angelegt wird, wenn vor der ausgangsseitigen Stirnseite eine Last angeordnet ist.

Der Plasmagenerator weist eine Ansteuerelektronik auf, die dazu ausgestaltet ist, zumindest einen Betriebsparameter des piezoelektrischen Transformators zu messen und anhand der Messung des Betriebsparameters eine vor der ausgangsseitigen Stirnseite angeordnete Last zu erkennen. Durch das Vorhandensein der Last vor der ausgangsseitigen Stirnseite kann der zumindest eine Betriebsparameter verändert werden. Bei dem zumindest einen Betriebsparameter kann es sich um eine Phase zwischen Eingangsstrom und Eingangsspannung, eine Impedanz des Transformators oder eine Resonanzfrequenz des Transformators handeln. Die hier genannten Betriebsparameter wechselwirken miteinander. Die Betriebsparameter können durch eine vor der ausgangsseitigen Stirnseite angeordnete Last beeinflusst und verändert werden. Dabei kann die Last eine von dem Transformator erzeugtes elektrisches Feld verändern und dadurch eine Änderung der Betriebsparameter bewirken.

Die Ansteuerelektronik kann dazu ausgestaltet sein, eine Wechselspannung an den Eingangsbereich des Transformators anzulegen.

Durch die Positionierung einer Last vor der ausgangsseitigen Stirnseite kann die elektrische Feldstärke eines von dem piezoelektrischen Transformator erzeugten elektrischen Felds auf die Ecken der ausgangsseitigen Stirnseite und deren unmittelbare Umgebung konzentriert werden, sodass Plasmazündungen entlang der längsseitigen Kanten des Ausgangsbereichs vermieden werden können. Ist keine Last vor der ausgangsseitigen Stirnseite angeordnet, ist das vom piezoelektrischen Transformator erzeugte elektrische Feld ungerichtet und weist in alle Raumrichtungen, wobei das Feld auch entlang der längsseitigen Kanten des Ausgangsbereichs erhebliche Feldkomponenten aufweist. Die Last vor der ausgangsseitigen Stirnseite sorgt für eine Führung des elektrischen Feldes, sodass eine maximale Feldstärke an den Ecken der ausgangsseitigen Stirnseite erreicht wird.

Die Last kann durch jedes beliebige Objekt gebildet werden. Die Last kann insbesondere durch ein Objekt gebildet werden, das durch den Plasmagenerator zu bearbeiten ist. Die Last kann beispielsweise durch eine Oberfläche oder einen Gegenstand gebildet werden, die zur Bearbeitung mit von dem Plasmagenerator erzeugten Plasma vorgesehen sind. Alternativ kann die Last auch durch ein permanent in der Nähe der ausgangsseitigen Stirnseite angeordnetes Objekt gebildet werden, dass nicht dem Plasma ausgesetzt ist und dass ebenfalls mit dem elektrischen Feld wechselwirkt und für die gewünschte Führung des Feldes sorgt. Eine solche Last wird auch als passive Last bezeichnet.

Die Last kann als vor der ausgangsseitigen Stirnseite des piezoelektrischen Transformators angesehen werden, wenn die Last sich innerhalb eines Halbraums befindet, der mittels der Ebene aufgespannt wird, in der sich die ausgangsseitige Stirnseite befindet, wobei die Flächennormale der ausgangsseitige Stirnseite, die vom Eingangsbereich des Transformators weg weist, in den Halbraum hineinweist. Ferner könnte die Last nur dann als vor der ausgangsseitigen Stirnseite angeordnet angesehen werden, wenn der Abstand zwischen der ausgangsseitigen Stirnseite und der Last nicht größer als ein Maximalabstand ist. Der Maximalabstand kann dabei derart gewählt sein, dass die Last in ausreichender Weise ein von dem piezoelektrischen Transformator erzeugtes elektrisches Feld beeinflussen kann. Der Maximalabstand kann beispielsweise 80 mm, vorzugsweise 40 mm, betragen.

Der Plasmagenerator kann eine Ansteuerelektronik aufweisen, die dazu ausgestaltet ist die Wechselspannung an den Eingangsbereich anzulegen. Der Plasmagenerator kann beispielsweise derart dazu ausgestaltet sein, nur dann eine zur Zündung eines nichtthermisches Atmosphärendruck-Plasmas ausreichende Leistung an den Eingangsbereich des piezoelektrischen Transformators anzulegen, indem die Ansteuerelektronik dazu ausgestaltet ist, die an den Eingangsbereich angelegte Wechselspannung zu variieren, abhängig davon, ob ein Objekt vor der ausgangsseitigen Stirnseite angeordnet ist. Ist ein Objekt vor der ausgangsseitigen Stirnseite angeordnet, so könnte die Ansteuerelektronik eine Wechselspannung an den Eingangsbereich anlegen, die hoch genug ist, um eine Plasmazündung im Ausgangsbereich auszulösen. Ist dagegen kein Objekt vor der ausgangsseitigen Stirnseite angeordnet, so könnte die Ansteuerelektronik entweder keine Wechselspannung an den Eingangsbereich anlegen oder eine Wechselspannung angelegen, die zu schwach ist, um eine Plasmazündung im Ausgangsbereich auszulösen.

Handelt es sich bei der Last um eine passive Last, die dauerhaft vor der ausgangsseitigen Stirnseite angeordnet ist, kann stets eine zur Plasmazündung ausreichende Leistung an den Transformator anlegbar sein.

Bei dem piezoelektrischen Transformator kann es sich um den oben beschriebenen Rosen-Transformator handeln. Der Transformator kann dazu ausgestaltet sein, dass eine Wechselspannung an den Eingangsbereich angelegt werden kann. In dem Eingangsbereich des Transformators können erste und zweite Innenelektroden und piezoelektrisches Material abwechselnd übereinandergestapelt sein. Ferner können Außenelektroden im Eingangsbereich auf den Außenflächen des Transformators derart angeordnet sein, dass die Innenelektroden in Stapelrichtung abwechselnd mit der ersten oder der zweiten Außenelektrode elektrisch kontaktiert sind.

Der Ausgangsbereich kann ein piezoelektrisches Material aufweisen, das bei an den Eingangsbereich angelegter Wechselspannung den Aufbau eines elektrischen Feldes bewirkt. Der Ausgangsbereich kann frei von Innenelektroden sein. Der Ausgangsbereich kann ein monolithischer Stack aus piezoelektrischem Material sein. Der Ausgangsbereich kann aus piezoelektrischem Material bestehen, das in Längsrichtung polarisiert ist.

Der Plasmagenerator kann eine Vorrichtung zur Erkennung eines vor der ausgangsseitigen Stirnseite des piezoelektrischen Transformators angeordneten Objekts aufweisen, wobei das Objekt die vor der ausgangsseitigen Stirnseite angeordnete Last bildet. Der Plasmagenerator kann derart ausgestaltet sein, dass nur dann an den Eingangsbereich eine zur Erzeugung des nichtthermischen Atmosphärendruck-Plasmas ausreichende Leistung angelegt wird, wenn die Vorrichtung ein vor der ausgangsseitigen Stirnseite angeordnetes Objekt erkennt.

Auf diese Weise können Zündungen von Plasma verhindert werden, solange keine Last vor dem Ausgang positioniert ist.

Die Objekterkennung kann beispielsweise mechanisch, optisch oder auf Basis einer Impedanz- oder Phasenmessung an dem piezoelektrischen Transformator erfolgen.

Die Vorrichtung zur Erkennung eines vor der ausgangsseitigen Stirnseite angeordneten Objekts kann beispielsweise ein mechanisches Tastelement aufweisen, das in Längsrichtung über die ausgangsseitige Stirnseite hinausragt. Das mechanische Tastelement kann insbesondere dazu ausgestaltet sein, eine Berührung eines Objektes zu erkennen und in diesem Fall die Plasmaerzeugung freizugeben. Ein solches mechanisches Tastelement stellt ein einfaches und zuverlässiges System zur Objekterkennung dar.

Das Tastelement kann ferner für einen Nutzer des Plasmagenerators eine zusätzliche Hilfe bei der Ausrichtung des Plasmagenerators zu einem zu behandelnden Objekt darstellen, da das Tastelement beispielsweise durch seine Länge den Nutzer auf einen optimalen Betriebsabstand zwischen dem Plasmagenerator und dem Objekt hinweisen kann.

Das Tastelement kann derart angeordnet sein, dass das mechanische Tastelement von einem Objekt betätigt wird, wenn das Objekt sich in einem Betriebsabstand vor dem piezoelektrischen Transformator befindet. Die Betätigung durch das Objekt kann zu einem mechanischen Widerstand führen, der von dem Tastelement erfasst wird.

Die Vorrichtung zur Erkennung eines vor der ausgangsseitigen Stirnseite angeordneten Objekts kann einen Schalter aufweisen, der dazu ausgestaltet ist, den piezoelektrischen Transformator ein- und auszuschalten und der mit dem mechanischen Tastelement derart verbunden ist, dass der Schalter den piezoelektrischen Transformator einschaltet, wenn das Tastelement ein Objekt vor der ausgangsseitigen Stirnseite erkennt.

Alternativ oder ergänzen kann die Vorrichtung zur Erkennung eines vor der ausgangsseitigen Stirnseite angeordneten Objektes eine optische Messvorrichtung aufweisen. Die optische Messvorrichtung kann dazu ausgestaltet sein, ein Ultraschallsignal auszusenden, eine Reflexion des Ultraschallsignals zu messen und auf Basis der gemessenen Reflexion eine Abstandsmessung vorzunehmen. Vorrichtungen zur optischen Abstandsmessung dieser Art erlauben eine Abstandsmessung mit einer hohen Präzision und können in einfacher Weise als Modul in dem Plasmagenerator ergänzt werden.

Der Plasmagenerator kann eine Ansteuerelektronik aufweisen, die dazu ausgelegt ist, eine Wechselspannung an den Eingangsbereich des piezoelektrischen Transformators anzulegen, wobei die Vorrichtung zur Erkennung eines vor der ausgangsseitigen Stirnseite angeordneten Objekts durch die Ansteuerelektronik ausgebildet ist, in dem die Ansteuerelektronik dazu ausgestaltet ist, eine Phase zwischen der an den Eingangsbereich angelegten Wechselspannung und eines über den piezoelektrischen Transformator fließenden Wechselstroms zu messen und aus der gemessenen Phase auf das Vorhandensein eines Objekts vor der ausgangsseitigen Stirnseite zu schließen. Ist ein Objekt vor der ausgangsseitigen Stirnseite vorhanden, so wechselwirkt dieses als kapazitive Last und als Lastwiderstand mit dem piezoelektrischen Transformator und sorgt dadurch für eine Phasenverschiebung im Eingangsbereich des Transformators. Die Ansteuerelektronik kann dazu ausgestaltet sein, eine solche Phasenverschiebung zu erkennen und dementsprechend auf das Vorhandensein eines Objektes zu schließen.

Die Ansteuerelektronik kann dazu ausgestaltet sein, den piezoelektrischen Transformator nach dem Einschalten des Plasmagenerators zunächst derart zu betreiben, dass eine Leistung an dem piezoelektrischen Transformator angelegt wird, die zur Zündung eines Plasmas nicht ausreicht, und das bei Betrieb des piezoelektrischen Transformators im Leerlauf die Phase zwischen der an den Eingangsbereich angelegten Wechselspannung und dem Wechselstrom in einem festgelegten Bereich zwischen α und β liegt, wobei die Ansteuerelektronik ferner dazu ausgestaltet sein kann, die an den piezoelektrischen Transformator angelegte Leistung zu erhöhen, wenn die Phase um einen festgelegten Wert von dem Bereich zwischen α und β abweicht. α und β können beispielsweise -5° und +5° sein. Vorzugsweise wird eine Phase von 0° gewählt, wenn der piezoelektrische Transformator im Leerlauf betrieben wird.

Als "Leerlauf" kann hier eine Situation bezeichnet werden, in der keine Last in unmittelbarer Nähe zu dem piezoelektrischen Transformator angeordnet ist, die den Verlauf des elektrischen Feldes beeinflussen könnte. Der piezoelektrische Transformator kann sich im Leerlauf befinden, wenn der piezoelektrische Transformator von einem mit Plasma zu behandelnden Objekt so weit entfernt ist, dass das Objekt ein von dem Transformator erzeugtes elektrisches Feld nicht wesentlich beeinflusst.

Bei der Last kann es sich um eine permanent vor der ausgangsseitigen Stirnseite angeordnete passive Last handeln. Eine Last wird hierbei als passive Last bezeichnet, wenn die Last nicht von einem zu behandelnden Objekt gebildet wird. Die Last kann als passive Last bezeichnet werden, wenn keine elektrische Spannung an die Last angelegt wird.

Die permanent vor der ausgangsseitigen Stirnseite angeordnete passive Last kann ein von dem Transformator erzeugtes elektrisches Feld stets derart beeinflussen, dass die elektrische Feldstärke auf die Ecken der ausgangsseitigen Stirnseite konzentriert wird. Somit können Plasmazündungen an den längsseitigen Kanten ausgeschlossen werden.

Der Plasmagenerator kann ein Gehäuse aufweisen, in dem der piezoelektrische Transformator angeordnet ist. Das Gehäuse kann eine Plasmaaustrittsöffnung aufweisen, wobei von dem piezoelektrischen Transformator gezündetes Plasma den Plasmagenerator über die Plasmaaustrittsöffnung verlässt. Die passive Last kann in unmittelbarer Nähe zu der Plasmaaustrittsöffnung angeordnet sein.

Die Last kann ringförmig sein, wobei der Ring einen inneren Durchmesser aufweisen kann, der größer ist als die Kantenlängen der ausgangsseitigen Stirnseite. Dementsprechend kann der Ring die ausgangsseitige Stirnseite umschließen.

Die passive Last kann ein isolierendes Material, insbesondere Aluminiumoxid, aufweisen.

Der Plasmagenerator kann ein Gehäuse aus einem ersten Material aufweisen, in dem der piezoelektrische Transformator angeordnet ist, wobei die passive Last ein zweites Material aufweist, wobei die Dielektrizitätskonstante des zweiten Materials höher ist als die Dielektrizitätskonstante des ersten Materials. Dementsprechend kann die passive Last die Feldführung des elektrischen Feldes stärker beeinflussen als das Gehäuse.

Die passive Last kann aus einem elektrisch leitfähigen Material oder aus einem halbleitenden Material bestehen, wobei zwischen der Last und dem piezoelektrischen Transformator ein isolierendes Material angeordnet ist. Das isolierende Material kann beispielsweise das Gehäuse sein. Das isolierende Material sorgt dafür, dass es keine Plasmaentladungen zwischen dem Transformator und der passiven Last gibt.

Der Ausgangsbereich des piezoelektrischen Transformators kann frei von einer Isolierung, beispielsweise einem Schrumpfschlauch, sein. Aufgrund der oben beschriebenen Ausgestaltung des Plasmagenerators, bei der Plasma nur dann erzeugt wird, wenn eine Last vor der ausgangsseitigen Stirnseite des Transformators angeordnet ist, kann auf eine solche Isolierung zur Vermeidung von unerwünschten Plasmazündungen entlang der längsseitigen Kanten verzichtet werden. Eine solche Isolierung würde zu einer Dämpfung der Schwingungen des piezoelektrischen Transformators führen, wodurch der Wirkungsgrad reduziert würde und ferner die Lebensdauer des Transformators verringert würde. In einem alternativen Ausführungsbeispiel kann zusätzlich eine solche Isolierung des Ausgangsbereichs als weitere Maßnahme zur Vermeidung von unerwünschten Plasmazündungen vorgesehen sein.

Der piezoelektrische Transformator kann dazu ausgestaltet sein, an seiner ausgangsseitigen Stirnseite das nichtthermische Atmosphärendruck-Plasma zu zünden.

Gemäß einem weiteren Aspekt wird ein Plasmagenerator zur Erzeugung von nichtthermischem Atmosphärendruck-Plasma vorgeschlagen, der einen piezoelektrischen Transformator aufweist, der in Längsrichtung in einen Eingangsbereich und einen Ausgangsbereich unterteilt ist, wobei der piezoelektrische Transformator eine ausgangsseitige Stirnseite, die vom Eingangsbereich weg weist, aufweist, wobei der Plasmagenerator eine permanent vor der ausgangsseitigen Stirnseite angeordnete passive Last aufweist.

Da die passive Last permanent vor der ausgangsseitigen Stirnseite angeordnet ist, kann stets die zur Plasmazündung erforderliche Leistung an den Transformator angelegt werden, da die Last dauerhaft dafür sorgen kann, dass ein vom Transformator erzeugtes elektrischen Feld von der Last geführt, insbesondere gebündelt, wird. Eine Vorrichtung zum Erkennen einer Last bzw. eine Ansteuerschaltung, die dazu ausgestaltet ist, anhand von Messungen zumindest eines Betriebsparameters das Vorhandensein einer Last zu erkennen, sind in dieser Ausführungsform nicht erforderlich. Sie können aber in alternativen Ausgestaltungen vorhanden sein.

Die Last kann ringförmig sein und der Ring kann einen inneren Durchmesser aufweisen, der größer ist als die Kantenlängen der ausgangsseitigen Stirnseite. Die passive Last kann ein isolierendes Material, insbesondere Aluminiumoxid, aufweist. Der Plasmagenerator kann ein Gehäuse aus einem ersten Material aufweisen, in dem der piezoelektrische Transformator angeordnet ist, wobei die passive Last ein zweites Material aufweist, wobei die Dielektrizitätskonstante des zweiten Materials höher ist als die Dielektrizitätskonstante des ersten Materials. Die passive Last kann aus einem elektrisch leitfähigen Material oder einem halbleitenden Material bestehen, wobei zwischen der Last und dem piezoelektrischen Transformator ein isolierendes Material angeordnet ist. Der piezoelektrische Transformator kann dazu ausgestaltet sein, an seiner ausgangsseitigen Stirnseite das nichtthermische Atmosphärendruck-Plasma zu zünden.

Im Folgenden sind vorteilhafte Aspekte beschrieben. Um eine Referenzierung zu erleichtern sind die Aspekte durchnummeriert. Merkmale der Aspekte sind nicht nur in Kombination mit dem speziellen Aspekt, auf den sie sich beziehen, sondern auch separat betrachtet relevant.
1. Plasmagenerator zur Erzeugung von nichtthermischem Atmosphärendruck-Plasma,
   aufweisend einen piezoelektrischen Transformator,
   der in Längsrichtung in einen Eingangsbereich und einen Ausgangsbereich unterteilt ist,
   wobei der piezoelektrische Transformator eine ausgangsseitige Stirnseite, die vom Eingangsbereich weg weist, aufweist,
   wobei der Plasmagenerator derart ausgestaltet ist, dass nur dann eine zur Zündung eines nichtthermisches Atmosphärendruck-Plasmas ausreichende Leistung an den Eingangsbereich des piezoelektrischen Transformators angelegt wird, wenn vor der ausgangsseitigen Stirnseite eine Last angeordnet ist.
2. Plasmagenerator gemäß dem vorherigen Aspekt,
   der eine Vorrichtung zur Erkennung eines vor der ausgangsseitigen Stirnseite des piezoelektrischen Transformators angeordneten Objekts aufweist, das eine vor der ausgangsseitigen Stirnseite angeordnete Last bildet, und
   wobei der Plasmagenerator derart ausgestaltet ist, dass nur dann an den Eingangsbereich eine zur Erzeugung des nichtthermischen Atmosphärendruck-Plasmas ausreichende Leistung angelegt wird, wenn die Vorrichtung ein vor der ausgangsseitigen Stirnseite angeordnetes Objekt erkennt.
3. Plasmagenerator gemäß dem vorherigen Aspekt,
   wobei die Vorrichtung zur Erkennung eines vor der ausgangsseitigen Stirnseite angeordneten Objekts ein mechanisches Tastelement aufweist, das in Längsrichtung über die ausgangsseitige Stirnseite hinausragt.
4. Plasmagenerator gemäß dem vorherigen Aspekt,
   wobei das mechanische Tastelement derart angeordnet ist, dass das mechanische Tastelement von einem Objekt betätigt wird, wenn das Objekt sich in einem Betriebsabstand vor dem piezoelektrischen Transformator befindet.
5. Plasmagenerator gemäß einem der Aspekte 3 oder 4,
   wobei die Vorrichtung zur Erkennung eines vor der ausgangsseitigen Stirnseite angeordneten Objekts einen Schalter aufweist, der dazu ausgestaltet ist, den piezoelektrischen Transformator einzuschalten und auszuschalten und der mit dem mechanischen Tastelement derart verbunden ist, dass der Schalter den piezoelektrischen Transformator nur einschaltet, wenn das Tastelement ein Objekt vor der ausgangsseitigen Stirnseite erkennt.
6. Plasmagenerator gemäß einem der Aspekte 2 bis 5,
   wobei die Vorrichtung zur Erkennung eines vor der ausgangsseitigen Stirnseite angeordneten Objekts eine optische Messvorrichtung aufweist.
7. Plasmagenerator gemäß dem vorherigen Aspekt,
   wobei die optische Messvorrichtung dazu ausgestaltet ist, ein Ultraschallsignal auszusenden, eine Reflektion des Ultraschallsignals zu messen und auf Basis der gemessenen Reflektion eine Abstandsmessung vorzunehmen.
8. Plasmagenerator gemäß einem der Aspekte 2 bis 7,
   der eine Ansteuerelektronik aufweist, die dazu ausgestaltet ist, die Wechselspannung an den Eingangsbereich des piezoelektrischen Transformators anzulegen,
   wobei die Vorrichtung zur Erkennung eines vor der ausgangsseitigen Stirnseite angeordneten Objekts durch die Ansteuerelektronik ausgebildet ist, indem die Ansteuerelektronik dazu ausgestaltet ist, eine Phase zwischen der an den Eingangsbereich angelegten Wechselspannung und eines über den piezoelektrischen Transformator fließenden Wechselstroms zu messen und aus der gemessenen Phase auf das Vorhandensein eines Objekts vor der ausgangsseitigen Stirnseite zu schließen.
9. Plasmagenerator gemäß Aspekt 8,
   wobei die Ansteuerelektronik dazu ausgestaltet ist, den piezoelektrischen Transformator nach dem Einschalten des Plasmagenerators zunächst derart zu betreiben, dass eine Leistung an den piezoelektrischen Transformator angelegt wird, die zur Zündung eines Plasmas nicht ausreicht und dass bei Betrieb des piezoelektrischen Transformators im Leerlauf die Phase zwischen der an den Eingangsbereich angelegten Wechselspannung und dem Wechselstrom in einem festgelegten Bereich zwischen α und β liegt,
   wobei die Ansteuerelektronik dazu ausgestaltet ist, die an den piezoelektrischen Transformator angelegte Leistung zu erhöhen, wenn die Phase um einen festgelegten Wert von dem Bereich zwischen α und β abweicht.
10. Plasmagenerator gemäß einem der vorherigen Aspekte,
   wobei es sich bei der Last um eine permanent vor der ausgangsseitigen Stirnseite angeordnete passive Last handelt.
11. Plasmagenerator gemäß dem vorherigen Aspekt,
   wobei die Last ringförmig ist und der Ring einen inneren Druchmesser aufweist, der größer ist als die Kantenlängen der ausgangsseitigen Stirnseite.
12. Plasmagenerator einem der Aspekte 10 oder 11,
   wobei die passive Last ein isolierendes Material, insbesondere Aluminiumoxid, aufweist.
13. Plasmagenerator gemäß einem der Aspekte 10 bis 12,
   wobei der Plasmagenerator ein Gehäuse aus einem ersten Material aufweist, in dem der piezoelektrische Transformator angeordnet ist, und wobei die passive Last ein zweites Material aufweist, wobei die Dielektrizitätskonstante des zweiten Materials höher ist als die Dielektrizitätskonstante des ersten Materials.
14. Plasmagenerator gemäß einem der Aspekte 10 oder 11, wobei die passive Last aus einem elektrisch leitfähigen Material oder einem halbleitenden Material besteht und wobei zwischen der Last und dem piezoelektrischen Transformator ein isolierendes Material angeordnet ist.
15. Plasmagenerator gemäß einem der vorherigen Aspekte, wobei der Ausgangsbereich des piezoelektrischen Transformators frei von einer Isolierung ist

Ungeachtet dieser Aspekte ist die Erfindung durch die Ansprüche definiert.

Im Folgenden wird die vorliegende Erfindung anhand der Figuren beschrieben.
Figur 1 zeigt einen piezoelektrischen Transformator in perspektivischer Ansicht.
Figur 2 zeigt einen Plasmagenerator gemäß einem ersten Ausführungsbeispiel.
Figur 3 zeigt einen Plasmagenerator gemäß einem zweiten Ausführungsbeispiel.
Figur 4 zeigt einen Plasmagenerator gemäß einem dritten Ausführungsbeispiel.
Figur 5 zeigt einen Plasmagenerator gemäß einem vierten Ausführungsbeispiel.

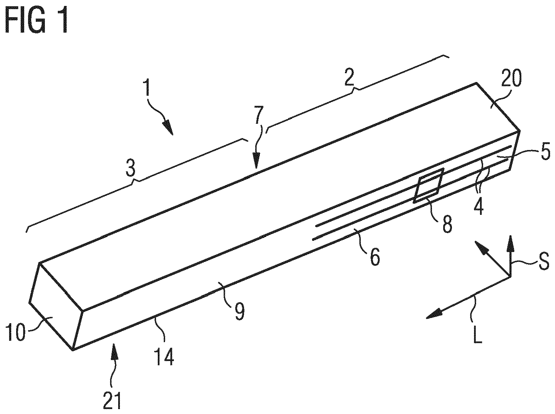

Figur 1 zeigt einen piezoelektrischen Transformator 1 in einer perspektivischen Ansicht. Der piezoelektrische Transformator 1 kann insbesondere in einem Plasmagenerator zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer Längsrichtung L an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der Längsrichtung L des piezoelektrischen Transformators 1. Die Elektroden 4 sind in einer Stapelrichtung S, die senkrecht zu der Längsrichtung L ist, abwechselnd mit einem piezoelektrischen Material 5 gestapelt. Das piezoelektrische Material 5 ist dabei in Stapelrichtung S polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung S abwechselnd entweder mit der ersten Außenelektrode 8 oder der zweiten Außenelektrode elektrisch kontaktiert.

Ferner weist der piezoelektrische Transformator 1 eine dritte Seitenfläche 20 und eine vierte Seitenfläche 21 auf, die einander gegenüberliegen und die senkrecht zu der ersten Seitenfläche 6 und der zweiten Seitenfläche 7 angeordnet sind. Die Flächennormalen der dritten und der vierten Seitenflächen 20, 21 zeigen jeweils in Stapelrichtung S.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich 3 ist in der Längsrichtung L polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der Längsrichtung L polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein Prozessgas ionisiert.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

Der Plasmagenerator weist ferner eine Ansteuerelektronik 11 auf. Die Ansteuerelektronik 11 ist dazu ausgestaltet, eine Wechselspannung an den Eingangsbereich 2 des piezoelektrischen Transformators 1 anzulegen.

Der Plasmagenerator weist ferner ein Gehäuse 12 auf. Der piezoelektrische Transformator 1 und die Ansteuerelektronik 11 sind in dem Gehäuse 12 angeordnet. Das Gehäuse 12 ist röhrenförmig. Das Gehäuse 12 weist ein elektrisch isolierendes Material auf. Das Gehäuse 12 weist eine Plasmaaustrittsöffnung 13 auf. Der piezoelektrische Transformator 1 ist derart in dem Gehäuse 12 angeordnet, dass sich die ausgangsseitige Stirnseite 10 in der Nähe der Plasmaaustrittsöffnung 13 befindet.

Das im Ausgangsbereich 3 des piezoelektrischen Transformators 1 erzeugte elektrische Feld ist im Leerlauf des piezoelektrischen Transformators 1 ungerichtet und weist dementsprechend in alle Raumrichtungen. Durch die Anordnung einer Last vor der ausgangsseitigen Stirnseite 10 kann das elektrische Feld, das von dem piezoelektrischen Transformator 1 erzeugt wird, geführt werden. Das Feld wird dabei insbesondere zu der Last hin geführt. Dadurch werden die Feldkomponenten entlang der längsseitigen Kanten 14 geschwächt. Dementsprechend kommt es in diesem Fall nicht zu den unerwünschten Plasmazündungen entlang der längsseitigen Kanten 14.

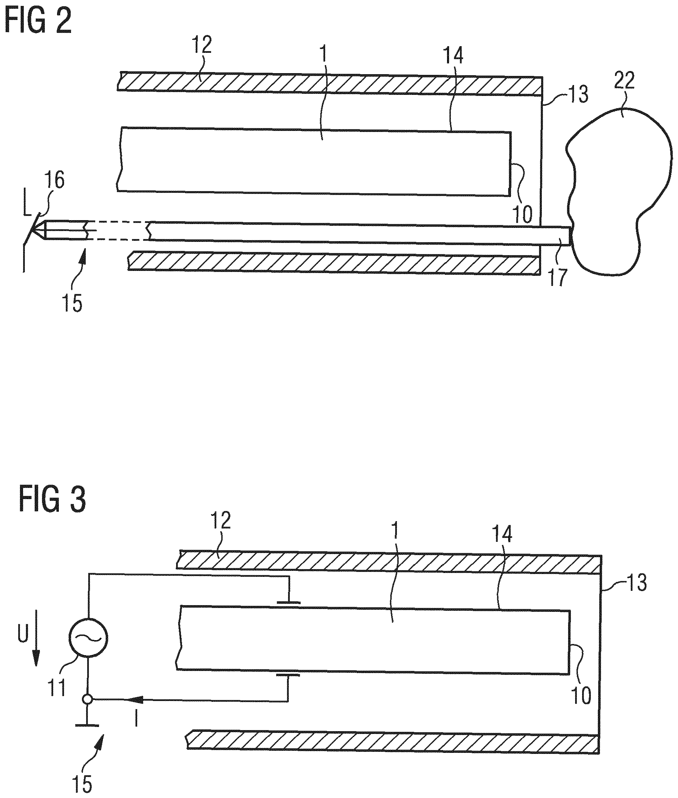

Figur 2 zeigt ein erstes Ausführungsbeispiel eines Plasmagenerators, der dazu ausgestaltet ist, unerwünschte Plasmazündungen an den längsseitigen Kanten 14 im Ausgangsbereich 3 des piezoelektrischen Transformators 1 zu vermeiden. Dazu ist der Plasmagenerator derart ausgestaltet, dass nur dann eine Zündung eines nichtthermischen Atmosphärendruck-Plasmas möglich ist, wenn vor der ausgangsseitigen Stirnseite 10 des piezoelektrischen Transformators 1 eine Last angeordnet ist. Diese Last kann beispielsweise durch eine zu behandelnde Oberfläche oder einen zu behandelnden Gegenstand gebildet werden. Die vor der ausgangsseitigen Stirnseite 10 angeordnete Last sorgt für eine Führung des elektrischen Feldes, wodurch sichergestellt werden kann, dass Plasma lediglich in Richtung der Last abgestrahlt wird.

Der in Figur 2 gezeigte Plasmagenerator weist eine Vorrichtung 15 zur Erkennung eines vor der ausgangsseitigen Stirnseite des piezoelektrischen Transformators 1 angeordneten Objektes 22 auf. Die Objekterkennung erfolgt in diesem Ausführungsbeispiel mechanisch. Dazu weist die Vorrichtung 15 einen Schalter 16 und ein mechanisches Tastelement 17 auf.

Das mechanische Tastelement 17 ragt über die ausgangsseitige Stirnseite 10 des Transformators 1 um einen Betriebsabstand hinaus. Das mechanische Tastelement 17 ist dazu ausgestaltet, zu erkennen, ob sich ein Objekt 22 an der Position befindet, an der eine vom piezoelektrischen Transformator 1 wegweisende Spitze des mechanischen Tastelements 17 angeordnet ist. Befindet sich dort ein Objekt 22, so stößt die Spitze gegen das Objekt 22 und das mechanische Tastelement 17 erfährt einen mechanischen Widerstand. Der Betriebsabstand ist so gewählt, dass er den idealen Abstand zwischen dem piezoelektrischen Transformator 1 und einer zu bearbeitenden Oberfläche bemisst. Der Betriebsabstand kann beispielsweise zwischen 1 mm und 40 cm liegen.

Der Schalter 16 kann einen geöffneten Zustand und einen geschlossenen Zustand einnehmen. Wenn das mechanische Tastelement 17 keinen mechanischen Widerstand erfährt, ist der Schalter 16 in seinem geöffneten Zustand. Wenn das mechanische Tastelement 17 einen mechanischen Widerstand erfährt, da es beispielsweise gegen ein Objekt 22 stößt, wird der Schalter 16 in seinen geschlossenen Zustand versetzt.

Ist der Schalter 16 geöffnet, so unterbricht der Schalter 16 eine elektrische Verbindung zwischen der Ansteuerelektronik 11 und dem piezoelektrischen Transformator 1, sodass keine Spannung an den Eingangsbereich 2 des piezoelektrischen Transformators 1 angelegt wird. Wenn der Schalter 16 geschlossen ist, ist die Ansteuerelektronik 11 mit dem piezoelektrischen Transformator 1 elektrisch verbunden und es kann eine Spannung an den Transformator 1 angelegt werden. Dementsprechend kann nur bei geschlossenem Schalter 16 Plasma erzeugt werden. Der Schalter 16 wird geschlossen, wenn das mechanische Tastelement 17 ein vor der ausgangsseitigen Stirnseite 10 angeordnetes Objekt 22 erkennt, das als elektrische Last wirkt.

Der Plasmagenerator gemäß dem ersten Ausführungsbeispiel ist dementsprechend derart konstruiert, dass eine Plasmazündung nur dann möglich ist, wenn sich ein Objekt 22 in dem definierten Betriebsabstand zu der ausgangsseitigen Stirnseite 10 befindet. Nur in diesem Fall wird das mechanische Tastelement 17 von dem Objekt 22 betätigt und gibt daraufhin die Plasmazündung frei. Auf diese Weise kann sichergestellt werden, dass der Plasmagenerator stets in dem idealen Betriebsabstand zu einem zu bearbeitenden Objekt 22 angeordnet wird.

Alternativ oder ergänzend zu der hier gezeigten Vorrichtung 15 zur Erkennung eines vor der ausgangsseitigen Stirnseite 10 angeordneten Objektes, die den Schalter 16 und das mechanische Tastelement 17 aufweist, kann auch eine optische Abstandsmessung vorgenommen werden. Dabei kann die Vorrichtung 15 eine optische Messvorrichtung (nicht gezeigt) aufweisen, die dazu ausgestaltet ist, ein Ultraschallsignal auszusenden, dessen Reflexion zu messen und auf Basis der gemessenen Reflexion eine Abstandsmessung vorzunehmen. Auf diese Weise kann erkannt werden, ob unmittelbar vor der ausgangsseitigen Stirnseite 10 des piezoelektrischen Transformators 1 ein zu behandelndes Objekt angeordnet ist. Entsprechende optische Messvorrichtungen können diese Messungen mit hoher Genauigkeit vornehmen.

Der Plasmagenerator ist derart ausgestaltet, dass erst dann eine Plasmazündung ermöglicht wird, wenn die optische Abstandsmessung ergibt, dass ein Objekt hinreichend nahe vor der ausgangsseitigen Stirnseite 10 des Transformators 1 angeordnet ist. Insbesondere kann ein Schwellwert für einen Mindestabstand festgelegt sein. Nur wenn die optische Abstandsmessung ergibt, dass sich ein Objekt in einem Abstand zu der ausgangsseitigen Stirnseite 10 befindet, der kleiner ist als der festgelegte Mindestabstand, kann eine Plasmazündung ermöglicht werden.

Ergibt die optische Abstandsmessung dagegen, dass kein Objekt hinreichend nahe vor der ausgangsseitigen Stirnseite 10 angeordnet ist, kann die Ansteuerelektronik 11 so programmiert sein, dass keine Spannung an den Eingangsbereich 2 des Transformators 1 angelegt wird.

Figur 3 zeigt einen Plasmagenerator gemäß einem zweiten Ausführungsbeispiel. Die Ansteuerelektronik 11 des Plasmagenerators, die dazu ausgestaltet ist, eine Wechselspannung an den Eingangsbereich 2 des piezoelektrischen Transformators 1 anzulegen, bildet gemäß dem zweiten Ausführungsbeispiel die Vorrichtung 15 zur Erkennung eines vor der ausgangsseitigen Stirnseite 10 angeordneten Objektes aus. In Figur 3 ist die Ansteuerelektronik 11 schematisch angedeutet.

Wird der Plasmagenerator eingeschaltet, so legt die Ansteuerelektronik 11 zunächst eine geringe Leistung an den piezoelektrischen Transformator 1 an, die derart gewählt ist, dass sie nicht ausreicht, um eine Plasmazündung im Ausgangsbereich 3 auszulösen. Die von der Ansteuerelektronik 11 an den Transformator 1 angelegte Leistung ist ferner derart gewählt, dass bei Betrieb des piezoelektrischen Transformators 1 im Leerlauf eine Phase zwischen der angelegten Wechselspannung und eines zugehörigen Wechselstroms zwischen -5° und +5°, vorzugsweise bei 0°, liegt. Die Ansteuerelektronik 11 ist dazu ausgestaltet, diese Phase ständig zu überwachen. Wird nunmehr der Plasmagenerator einem zu behandelnden Objekt angenähert, so wirkt das Objekt als ausgangsseitige Kapazität und als Lastwiderstand auf den piezoelektrischen Transformator 1 ein. Dadurch kommt es zu einer Verschiebung der Phase zwischen dem Wechselstrom und der Wechselspannung. Die Ansteuerelektronik 11 erkennt diese Phasenverschiebung. Überschreitet die Phasenverschiebung einen vordefinierten Schwellenwert, so interpretiert die Ansteuerelektronik 11 dieses als Nachweis für das vor der ausgangsseitigen Stirnseite 10 angeordnete Objekt. Ist auf diese Weise ein zu behandelndes Objekt erkannt, erhöht die Ansteuerelektronik 11 die an den piezoelektrischen Transformator 1 angelegte Leistung, sodass nunmehr auf der ausgangsseitigen Stirnseite 10 ein nichtthermisches Atmosphärendruck-Plasma gezündet wird.

Wird der piezoelektrische Transformator 1 wieder von dem zu behandelnden Gegenstand entfernt, so führt dieses erneut zu einer Phasenverschiebung. Die Ansteuerelektronik 11 ist dazu ausgestaltet, eine solche Phasenverschiebung zu erkennen und daraufhin die an den piezoelektrischen Transformator 1 angelegte Leistung zu reduzieren, sodass es nicht länger zu Plasmazündungen kommt. Auf diese Weise wird der Transformator 1 vor dem Zünden von Plasma im Leerlauf geschützt.

Bei den oben beschriebenen Ausführungsbeispielen wird somit nur bei Vorhandensein eines Objektes vor der ausgangsseitigen Stirnseite 10 des Transformators 1 ein Plasma erzeugt, wobei das Objekt hinreichend nahe an der ausgangsseitigen Stirnseite 10 sein muss. Dabei sorgt das Objekt für eine Feldführung des Plasmas, die sicherstellt, dass Plasmazündungen an den längsseitigen Kanten 14 vermieden werden.

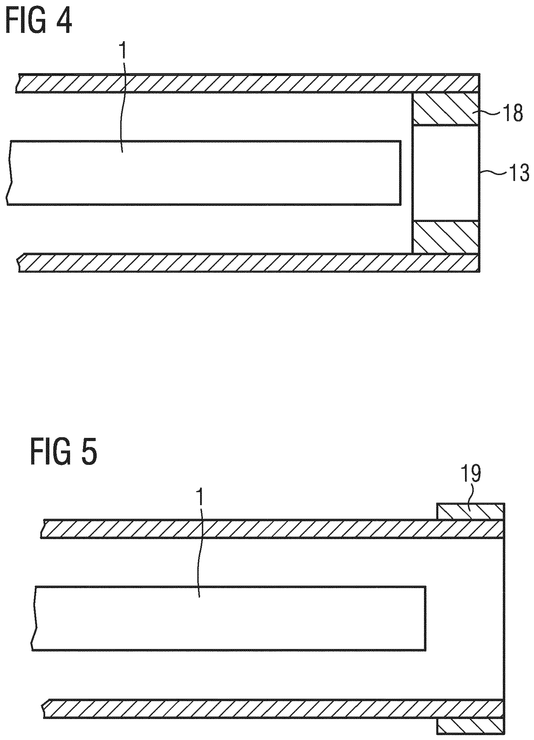

In Figur 4 ist ein drittes Ausführungsbeispiel des Plasmagenerators dargestellt. Der Plasmagenerator weist eine permanent vor der ausgangsseitigen Stirnseite 10 des piezoelektrischen Transformators 1 angeordnete passive Last 18 auf. Der Plasmagenerator gemäß dem dritten Ausführungsbeispiel kann stets zur Zündung von einem nichtthermischen Atmosphärendruck-Plasma verwendet werden, ohne dass es zu unerwünschten Plasmazündungen entlang der Kanten 14 kommt. Ein zu behandelndes Objekt, das als Last wirkt, muss nicht zwangsläufig vor der ausgangsseitigen Stirnseite 10 angeordnet sein. Die passive Last 18 wirkt vielmehr ebenfalls zur Feldführung.

Bei der passiven Last 18 kann es sich beispielsweise um ein ringförmiges Element handeln. Die passive Last 18 ist an einer Innenseite des röhrenförmigen Gehäuses 12 angeordnet. Die passive Last 18 ist an der Plasmaaustrittsöffnung 13 des Gehäuses angeordnet. Die passive Last 18 besteht aus einem Material bestehen, dessen Dielektrizitätszahl höher ist als die Dielektrizitätszahl des Materials des Gehäuses 12. Die passive Last 18 kann beispielsweise aus Aluminiumoxid bestehen.

Die passive Last 18 sorgt auf Grund ihrer elektrischen Eigenschaften dafür, dass sich das elektrische Feld, das vom piezoelektrischen Transformator 1 erzeugt wird, auf die Ecken der ausgangsseitigen Stirnseiten 10 konzentriert. Wird nunmehr eine aktive Last, beispielsweise ein zu behandelndes Objekt, vor die passive Last 18 gehalten, würde die aktive Last die Feldstärke wiederum besser bündeln als die passive Last 18, sodass das Plasma hauptsächlich der aktiven Last zugeführt würde und es durch die passive Last 18 nicht zu Leistungsverlusten kommt.

Figur 5 zeigt ein viertes Ausführungsbeispiel, bei dem statt einer passiven Last 18 aus einem isolierenden Material, eine passive Last 19 zur Feldführung verwendet wird, die ein elektrisch leitfähiges oder ein halbleitendes Material aufweist. Die passive Last 19 ist besser zur Feldführung geeignet als eine passive Last 18 aus einem isolierenden Material. Die passive Last 19 ist auf einer Außenseite des röhrenförmigen Gehäuses 12 angeordnet und umschließt die Plasmaaustrittsöffnung 13 des Gehäuses 12. Da das Gehäuse 12 aus einem isolierenden Material besteht, das zwischen der passiven Last 19 und dem piezoelektrischen Transformator 1 angeordnet ist, kann durch das Gehäuse 12 sichergestellt werden, dass es nicht zu einer direkten Plasmazündung zwischen dem Transformator 1 und der passiven Last 19 kommt.

Auch die passive Last 19, die ein leitendes oder halbleitendes Material aufweist, wirkt im Wesentlichen wie die im dritten Ausführungsbeispiel beschriebene passive Last 18. Die Last 19 bewirkt, dass das elektrischen Feld, das vom Transformator 1 erzeugt wird, auf der ausgangsseitigen Stirnseite 10 des Transformators 1 konzentriert wird, dass das Feld geführt wird und dass auf diese Weise Plasmazündungen entlang den ausgangsseitigen längsseitigen Kanten 14 vermieden werden.

Aufgrund der in den Ausführungsbeispielen geschilderten Maßnahmen ist sichergestellt, dass es nur dann zu einer Plasmazündung kommt, wenn eine Last vor der ausgangsseitigen Stirnseite 10 angeordnet ist. Aus diesem Grund kann in sämtlichen Ausführungsbeispielen auf die Isolierung des Ausgangsbereichs 3 verzichtet werden. Andernfalls wäre eine solche Isolierung, beispielsweise durch einen Schrumpfschlauch, nötig, um Plasmazündungen entlang der längsseitigen Kanten zu vermeiden.

Die hier beschriebenen Ausführungsbeispiele sind miteinander kombinierbar. Beispielsweise kann der piezoelektrische Transformator 1 sowohl eine passive Last 18, 19 gemäß dem dritten oder vierten Ausführungsbeispiel als auch eine Vorrichtung 15 zur Erkennung eines vor der ausgangsseitigen Stirnseite 10 angeordneten Objekts gemäß dem ersten oder zweiten Ausführungsbeispiel aufweisen. Nur wenn die Vorrichtung 15 ein solches Objekt erkennt, kann eine Plasmaerzeugung ermöglicht werden. Die passive Last 18, 19 kann in diesem Fall zu einer weiter verbesserten Feldführung beitragen, indem die passive Last 18, 19 das elektrische Feld, das von dem piezoelektrischen Transformator 1 erzeugt wird, weiter konzentriert.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: Ansteuerelektronik
- 12: Gehäuse
- 13: Plasmaaustrittsöffnung
- 14: längsseitige Kante
- 15: Vorrichtung zur Erkennung eines vor der ausgangsseitigen Stirnseite des piezoelektrischen Transformators angeordneten Objektes
- 16: Schalter
- 17: mechanisches Tastelement
- 18: passive Last aus isolierendem Material
- 19: passive Last aus leitendem oder halbleitendem Material
- 20: dritte Seitenfläche
- 21: vierte Seitenfläche
- 22: Objekt

- L: Längsrichtung
- S: Stapelrichtung

## Patentansprüche

1. Plasmagenerator zur Erzeugung von nichtthermischem Atmosphärendruck-Plasma,
aufweisend einen piezoelektrischen Transformator (1), der in Längsrichtung (L) in einen Eingangsbereich (2) und einen Ausgangsbereich (3) unterteilt ist,
wobei der piezoelektrische Transformator (1) eine ausgangsseitige Stirnseite (10), die vom Eingangsbereich (2) weg weist, aufweist, **dadurch gekennzeichnet, dass** der Plasmagenerator derart ausgestaltet ist, dass nur dann eine zur Zündung eines nichtthermisches Atmosphärendruck-Plasmas ausreichende Leistung an den Eingangsbereich (2) des piezoelektrischen Transformators (1) angelegt wird, wenn vor der ausgangsseitigen Stirnseite (10) eine Last (18, 19, 22) angeordnet ist, wobei der Plasmagenerator eine Ansteuerelektronik (11) aufweist, die dazu ausgestaltet ist, zumindest einen Betriebsparameter des piezoelektrischen Transformators zu messen und anhand der Messung des Betriebsparameters eine vor der ausgangsseitigen Stirnseite (10) angeordnete Last (22) zu erkennen.

2. Plasmagenerator gemäß dem vorherigen Anspruch,
wobei es sich bei dem zumindest einen Betriebsparameter um eine Phase zwischen der an den Eingangsbereich (2) angelegten Wechselspannung und eines über den piezoelektrischen Transformator (1) fließenden Wechselstroms handelt.

3. Plasmagenerator gemäß Anspruch 2,
wobei die Ansteuerelektronik (11) dazu ausgestaltet ist, den piezoelektrischen Transformator (1) nach dem Einschalten des Plasmagenerators zunächst derart zu betreiben, dass eine Leistung an den piezoelektrischen Transformator (1) angelegt wird, die zur Zündung eines Plasmas nicht ausreicht und dass bei Betrieb des piezoelektrischen Transformators (1) im Leerlauf die Phase zwischen der an den Eingangsbereich (2) angelegten Wechselspannung und dem Wechselstrom in einem festgelegten Bereich liegt,
wobei die Ansteuerelektronik (11) dazu ausgestaltet ist, die an den piezoelektrischen Transformator (1) angelegte Leistung zu erhöhen, wenn die Phase um einen festgelegten Wert von dem Bereich abweicht.

4. Plasmagenerator gemäß einem der vorherigen Ansprüche,
wobei es sich bei dem zumindest einen Betriebsparameter um eine Impedanz des piezoelektrischen Transformators (1) handelt,
oder
wobei es sich bei dem zumindest einen Betriebsparameter um eine Resonanzfrequenz des piezoelektrischen Transformators (1) handelt.

5. Plasmagenerator gemäß einem der vorherigen Ansprüche, der eine Vorrichtung (15) zur Erkennung eines vor der ausgangsseitigen Stirnseite (10) des piezoelektrischen Transformators (1) angeordneten Objekts (22) aufweist, das eine vor der ausgangsseitigen Stirnseite (10) angeordnete Last bildet, und
wobei der Plasmagenerator derart ausgestaltet ist, dass nur dann an den Eingangsbereich (2) eine zur Erzeugung des nichtthermischen Atmosphärendruck-Plasmas ausreichende Leistung angelegt wird, wenn die Vorrichtung (15) ein vor der ausgangsseitigen Stirnseite (10) angeordnetes Objekt (22) erkennt.

6. Plasmagenerator gemäß dem vorherigen Anspruch,
wobei die Vorrichtung (15) zur Erkennung eines vor der ausgangsseitigen Stirnseite (10) angeordneten Objekts (22) ein mechanisches Tastelement (17) aufweist, das in Längsrichtung (L) über die ausgangsseitige Stirnseite (10) hinausragt.

7. Plasmagenerator gemäß dem vorherigen Anspruch,
wobei das mechanische Tastelement (17) derart angeordnet ist, dass das mechanische Tastelement (17) von einem Objekt (22) betätigt wird, wenn das Objekt (22) sich in einem Betriebsabstand vor dem piezoelektrischen Transformator (1) befindet.

8. Plasmagenerator gemäß einem der Ansprüche 6 oder 7,
wobei die Vorrichtung (15) zur Erkennung eines vor der ausgangsseitigen Stirnseite (10) angeordneten Objekts (22) einen Schalter (16) aufweist, der dazu ausgestaltet ist, den piezoelektrischen Transformator (1) einzuschalten und auszuschalten und der mit dem mechanischen Tastelement derart verbunden ist, dass der Schalter (16) den piezoelektrischen Transformator (1) nur einschaltet, wenn das Tastelement ein Objekt (22) vor der ausgangsseitigen Stirnseite (10) erkennt.

9. Plasmagenerator gemäß einem der Ansprüche 5 bis 8,
wobei die Vorrichtung (15) zur Erkennung eines vor der ausgangsseitigen Stirnseite (10) angeordneten Objekts (22) eine optische Messvorrichtung aufweist.

10. Plasmagenerator gemäß dem vorherigen Anspruch,
wobei die optische Messvorrichtung dazu ausgestaltet ist, ein Ultraschallsignal auszusenden, eine Reflektion des Ultraschallsignals zu messen und auf Basis der gemessenen Reflektion eine Abstandsmessung vorzunehmen.

11. Plasmagenerator gemäß einem der vorherigen Ansprüche,
wobei es sich bei der Last (18, 19) um eine permanent vor der ausgangsseitigen Stirnseite (10) angeordnete passive Last handelt.

12. Plasmagenerator gemäß dem vorherigen Anspruch,
wobei die Last (18, 19) ringförmig ist und der Ring einen inneren Durchmesser aufweist, der größer ist als die Kantenlängen der ausgangsseitigen Stirnseite (10).

13. Plasmagenerator einem der Ansprüche 11 oder 12,
wobei die passive Last (18) ein isolierendes Material, insbesondere Aluminiumoxid, aufweist.

14. Plasmagenerator gemäß einem der Ansprüche 11 bis 13,
wobei der Plasmagenerator ein Gehäuse (12) aus einem ersten Material aufweist, in dem der piezoelektrische Transformator (1) angeordnet ist, und wobei die passive Last (18) ein zweites Material aufweist, wobei die Dielektrizitätskonstante des zweiten Materials höher ist als die Dielektrizitätskonstante des ersten Materials.

15. Plasmagenerator gemäß einem der Ansprüche 11 oder 12,
wobei die passive Last (19) aus einem elektrisch leitfähigen Material oder einem halbleitenden Material besteht und wobei zwischen der Last (19) und dem piezoelektrischen Transformator (1) ein isolierendes Material angeordnet ist.

16. Plasmagenerator gemäß einem der vorherigen Ansprüche,
wobei der Ausgangsbereich (3) des piezoelektrischen Transformators (1) frei von einer Isolierung ist.

17. Plasmagenerator gemäß einem der vorherigen Ansprüche,
wobei der piezoelektrische Transformator (1) dazu ausgestaltet ist, an seiner ausgangsseitigen Stirnseite (10) das nichtthermische Atmosphärendruck-Plasma zu zünden.

18. Plasmagenerator zur Erzeugung von nichtthermischem Atmosphärendruck-Plasma,
aufweisend einen piezoelektrischen Transformator (1), der in Längsrichtung (L) in einen Eingangsbereich (2) und einen Ausgangsbereich (3) unterteilt ist,
wobei der piezoelektrische Transformator (1) eine ausgangsseitige Stirnseite (10), die vom Eingangsbereich (2) weg weist, aufweist, **dadurch gekennzeichnet, dass** der Plasmagenerator eine permanent vor der ausgangsseitigen Stirnseite (10) angeordnete passive Last (18, 19) aufweist.

19. Plasmagenerator gemäß dem vorherigen Anspruch,
der derart ausgestaltet ist, dass stets eine zur Zündung eines nichtthermischen Atmosphärendruck-Plasmas ausreichende Leistung an den Eingangsbereich (2) des piezoelektrischen Transformators (1) anlegbar ist.

20. Plasmagenerator gemäß der Ansprüche 18 oder 19,
wobei die Last (18, 19) ringförmig ist und der Ring einen inneren Durchmesser aufweist, der größer ist als die Kantenlängen der ausgangsseitigen Stirnseite (10).

21. Plasmagenerator einem der Ansprüche 18 bis 20,
wobei die passive Last (18) ein isolierendes Material, insbesondere Aluminiumoxid, aufweist.

22. Plasmagenerator gemäß einem der Ansprüche 18 bis 21,
wobei der Plasmagenerator ein Gehäuse (12) aus einem ersten Material aufweist, in dem der piezoelektrische Transformator (1) angeordnet ist, und wobei die passive Last (18) ein zweites Material aufweist, wobei die Dielektrizitätskonstante des zweiten Materials höher ist als die Dielektrizitätskonstante des ersten Materials.

23. Plasmagenerator gemäß einem der Ansprüche 18 bis 20,
wobei die passive Last (19) aus einem elektrisch leitfähigen Material oder einem halbleitenden Material besteht und wobei zwischen der Last (19) und dem piezoelektrischen Transformator (1) ein isolierendes Material angeordnet ist.

24. Plasmagenerator gemäß einem der vorherigen Ansprüche,
wobei der piezoelektrische Transformator (1) dazu ausgestaltet ist, an seiner ausgangsseitigen Stirnseite (10) das nichtthermische Atmosphärendruck-Plasma zu zünden.

## Claims

1. Plasma generator for generating non-thermal atmospheric-pressure plasma,
comprising a piezoelectric transformer (1), which is subdivided in a longitudinal direction (L) into an input region (2) and an output region (3), wherein the piezoelectric transformer (1) comprises an output-side end face (10) facing away from the input region (2),
**characterized in that** the plasma generator is configured in such a way that a power sufficient for igniting a non-thermal atmospheric-pressure plasma is applied to the input region (2) of the piezoelectric transformer (1) only if a load (18, 19, 22) is arranged in front of the output-side end face (10),
wherein the plasma generator comprises a drive electronics unit (11) configured to measure at least one operating parameter of the piezoelectric transformer and, on the basis of the measurement of the operating parameter, to identify a load (22) arranged in front of the output-side end face (10).

2. Plasma generator according to the preceding claim,
wherein the at least one operating parameter is a phase between the AC voltage applied to the input region (2) and an AC current flowing via the piezoelectric transformer (1).

3. Plasma generator according to claim 2,
wherein the drive electronics unit (11) is configured firstly to operate the piezoelectric transformer (1) after the switch-on of the plasma generator in such a way that a power that is not sufficient for igniting a plasma is applied to the piezoelectric transformer (1) and that, during operation of the piezoelectric transformer (1) under no load, the phase between the AC voltage applied to the input region (2) and the AC current lies in a defined range,
wherein the drive electronics unit (11) is configured to increase the power applied to the piezoelectric transformer (1) if the phase deviates from the range by a defined value.

4. Plasma generator according to any of the preceding claims,
wherein the at least one operating parameter is an impedance of the piezoelectric transformer (1),
or
wherein the at least one operating parameter is a resonant frequency of the piezoelectric transformer (1).

5. Plasma generator according to any of the preceding claims,
which comprises a device (15) for identifying an object (22) which is arranged in front of the output-side end face (10) of the piezoelectric transformer (1) and which forms a load arranged in front of the output-side end face (10), and
wherein the plasma generator is configured in such a way that a power sufficient for generating the non-thermal atmospheric-pressure plasma is applied to the input region (2) only if the device (15) identifies an object (22) arranged in front of the output-side end face (10) .

6. Plasma generator according to the preceding claim,
wherein the device (15) for identifying an object (22) arranged in front of the output-side end face (10) comprises a mechanical probe element (17), which projects beyond the output-side end face (10) in the longitudinal direction (L).

7. Plasma generator according to the preceding claim,
wherein the mechanical probe element (17) is arranged in such a way that the mechanical probe element (17) is actuated by an object (22) if the object (22) is situated at an operating distance in front of the piezoelectric transformer (1).

8. Plasma generator according to either of claims 6 and 7,
wherein the device (15) for identifying an object (22) arranged in front of the output-side end face (10) comprises a switch (16), which is configured to switch on and switch off the piezoelectric transformer (1) and which is connected to the mechanical probe element in such a way that the switch (16) switches on the piezoelectric transformer (1) only if the probe element identifies an object (22) in front of the output-side end face (10).

9. Plasma generator according to any of claims 5 to 8,
wherein the device (15) for identifying an object (22) arranged in front of the output-side end face (10) comprises an optical measuring device.

10. Plasma generator according to the preceding claim,
wherein the optical measuring device is configured to emit an ultrasonic signal, to measure a reflection of the ultrasonic signal and to carry out a distance measurement on the basis of the measured reflection.

11. Plasma generator according to any of the preceding claims,
wherein the load (18, 19) is a passive load arranged permanently in front of the output-side end face (10).

12. Plasma generator according to the preceding claim,
wherein the load (18, 19) is ring-shaped and the ring has an internal diameter that is greater than the edge lengths of the output-side end face (10).

13. Plasma generator according to either of claims 11 and 12,
wherein the passive load (18) comprises an insulating material, in particular aluminum oxide.

14. Plasma generator according to any of claims 11 to 13,
wherein the plasma generator comprises a housing (12) composed of a first material, in which the piezoelectric transformer (1) is arranged, and wherein the passive load (18) comprises a second material, wherein the relative permittivity of the second material is higher than the relative permittivity of the first material.

15. Plasma generator according to either of claims 11 and 12,
wherein the passive load (19) consists of an electrically conductive material or a semiconducting material and wherein an insulating material is arranged between the load (19) and the piezoelectric transformer (1) .

16. Plasma generator according to any of the preceding claims,
wherein the output region (3) of the piezoelectric transformer (1) is free of an insulation.

17. Plasma generator according to any of the preceding claims,
wherein the piezoelectric transformer (1) is configured to ignite the non-thermal atmospheric-pressure plasma at its output-side end face (10).

18. Plasma generator for generating non-thermal atmospheric-pressure plasma,
comprising a piezoelectric transformer (1), which is subdivided in the longitudinal direction (L) into an input region (2) and an output region (3), wherein the piezoelectric transformer (1) comprises an output-side end face (10) facing away from the input region (2),
**characterized in that** the plasma generator comprises a passive load (18, 19) arranged permanently in front of the output-side end face (10).

19. Plasma generator according to the preceding claim, which is configured in such a way that a power sufficient for igniting a non-thermal atmospheric-pressure plasma is always able to be applied to the input region (2) of the piezoelectric transformer (1).

20. Plasma generator according to either of claims 18 and 19,
wherein the load (18, 19) is ring-shaped and the ring has an internal diameter that is greater than the edge lengths of the output-side end face (10).

21. Plasma generator according to any of claims 18 to 20,
wherein the passive load (18) comprises an insulating material, in particular aluminum oxide.

22. Plasma generator according to any of claims 18 to 21,
wherein the plasma generator comprises a housing (12) composed of a first material, in which the piezoelectric transformer (1) is arranged, and wherein the passive load (18) comprises a second material, wherein the relative permittivity of the second material is higher than the relative permittivity of the first material.

23. Plasma generator according to any of claims 18 to 20,
wherein the passive load (19) consists of an electrically conductive material or a semiconducting material and wherein an insulating material is arranged between the load (19) and the piezoelectric transformer (1) .

24. Plasma generator according to any of the preceding claims,
wherein the piezoelectric transformer (1) is configured to ignite the non-thermal atmospheric-pressure plasma at its output-side end face (10).

## Revendications

1. Générateur de plasma destiné à générer un plasma non thermique à pression atmosphérique et comportant un transformateur piézoélectrique (1) qui est divisé dans la direction longitudinale (L) en une zone d'entrée (2) et une zone de sortie (3), le transformateur piézoélectrique (1) comportant une face frontale côté sortie (10) qui pointe à l'opposé de la zone d'entrée (2),
**caractérisé en ce que**
le générateur de plasma est conçu de façon à n'appliquer qu'une puissance suffisante pour amorcer un plasma non thermique à pression atmosphérique à la zone d'entrée (2) du transformateur piézoélectrique (1) lorsqu'une charge (18, 19, 22) est disposée devant la face frontale côté sortie (10), le générateur de plasma comportant une électronique de commande (11) qui est conçue pour mesurer au moins un paramètre de fonctionnement du transformateur piézoélectrique et, sur la base de la mesure du paramètre de fonctionnement, pour détecter une charge (22) disposée devant la face frontale côté sortie (10).

2. Générateur de plasma selon la revendication précédente, l'au moins un paramètre de fonctionnement étant une phase entre la tension alternative appliquée à la zone d'entrée (2) et un courant alternatif traversant le transformateur piézoélectrique (1).

3. Générateur de plasma selon la revendication 2, l'électronique de commande (11) étant conçue pour faire fonctionner d'abord le transformateur piézoélectrique (1) après l'activation du générateur de plasma de façon à appliquer au transformateur piézoélectrique (1) une puissance qui est insuffisante pour amorcer un plasma et de sorte que, pendant le fonctionnement du transformateur piézoélectrique (1) au ralenti, la phase entre la tension alternative appliquée à la zone d'entrée (2) et le courant alternatif se situe dans une plage spécifiée,
l'électronique de commande (11) étant conçue pour augmenter la puissance appliquée au transformateur piézoélectrique (1) lorsque la phase s'écarte de la plage d'une valeur spécifiée.

4. Générateur de plasma selon l'une des revendications précédentes,
l'au moins un paramètre de fonctionnement étant l'impédance du transformateur piézoélectrique (1), ou l'au moins un paramètre de fonctionnement étant la fréquence de résonance du transformateur piézoélectrique (1).

5. Générateur de plasma selon l'une des revendications précédentes, lequel comporte un dispositif (15) destiné à détecter un objet (22) disposé devant la face frontale côté sortie (10) du transformateur piézoélectrique (1), lequel objet forme une charge disposée devant la face frontale côté sortie (10), et
le générateur de plasma étant conçu de façon à n'appliquer qu'une puissance suffisante pour générer à la zone d'entrée (2) le plasma non thermique à pression atmosphérique lorsque le dispositif (15) détecte un objet (22) disposé devant la face frontale côté sortie (10) .

6. Générateur de plasma selon la revendication précédente,
le dispositif (15) destiné à détecter un objet (22) disposé devant la face frontale côté sortie (10) comportant un élément palpeur mécanique (17) qui fait saillie dans la direction longitudinale (L) de la face frontale côté sortie (10).

7. Générateur de plasma selon la revendication précédente,
l'élément palpeur mécanique (17) étant disposé de telle sorte que l'élément palpeur mécanique (17) soit actionné par un objet (22) lorsque l'objet (22) est situé à une distance de fonctionnement devant le transformateur piézoélectrique (1).

8. Générateur de plasma selon l'une des revendications 6 et 7,
le dispositif (15) destiné à détecter un objet (22) disposé sur la face frontale côté sortie (10) comportant un commutateur (16) qui active et désactive le transformateur piézoélectrique (1) et qui est relié à l'élément palpeur mécanique de telle sorte que le commutateur (16) n'active le transformateur piézoélectrique (1) que lorsque l'élément palpeur détecte un objet (22) devant la face frontale côté sortie (10).

9. Générateur de plasma selon l'une des revendications 5 à 8,
le dispositif (15) destiné à détecter un objet (22) disposé devant la face frontale côté sortie (10) comportant un dispositif de mesure optique.

10. Générateur de plasma selon la revendication précédente,
le dispositif de mesure optique étant conçu pour émettre un signal ultrasonore, mesurer une réflexion du signal ultrasonore et mesurer la distance sur la base de la réflexion mesurée.

11. Générateur de plasma selon l'une des revendications précédentes,
la charge (18, 19) étant une charge passive disposée en permanence devant la face frontale côté sortie (10).

12. Générateur de plasma selon la revendication précédente,
la charge (18, 19) étant en forme bague et la bague ayant un diamètre intérieur qui est supérieur aux longueurs de bord de la face frontale côté sortie (10).

13. Générateur de plasma selon l'une des revendications 11 et 12,
la charge passive (18) comportant un matériau isolant, notamment de l'oxyde d'aluminium.

14. Générateur de plasma selon l'une des revendications 11 à 13,
le générateur de plasma comportant un boîtier (12) en un premier matériau dans lequel est disposé le transformateur piézoélectrique (1), et la charge passive (18) comportant un deuxième matériau, la constante diélectrique du deuxième matériau étant supérieure à la constante diélectrique du premier matériau.

15. Générateur de plasma selon l'une des revendications 11 et 12,
la charge passive (19) étant en un matériau électriquement conducteur ou en un matériau semiconducteur et un matériau isolant étant disposé entre la charge (19) et le transformateur piézoélectrique (1) .

16. Générateur de plasma selon l'une des revendications précédentes,
la zone de sortie (3) du transformateur piézoélectrique (1) étant dépourvue d'isolant.

17. Générateur de plasma selon l'une des revendications précédentes,
le transformateur piézoélectrique (1) étant conçu pour amorcer le plasma non thermique à pression atmosphérique sur sa face frontale côté sortie (10).

18. Générateur de plasma destiné à générer un plasma non thermique à pression atmosphérique et comportant un transformateur piézoélectrique (1) qui est divisé dans la direction longitudinale (L) en une zone d'entrée (2) et une zone de sortie (3), le transformateur piézoélectrique (1) comportant une face frontale côté sortie (10) qui pointe à l'opposé de la zone d'entrée (2),
**caractérisé en ce que**
le générateur de plasma comporte une charge passive (18, 19) qui est disposée en permanence devant la face frontale côté sortie (10).

19. Générateur de plasma selon la revendication précédente,
lequel est conçu de façon à toujours appliquer à la zone d'entrée (2) du transformateur piézoélectrique (1) une puissance suffisante pour amorcer un plasma non thermique à pression atmosphérique.

20. Générateur de plasma selon l'une des revendications 18 et 19,
la charge (18, 19) étant en forme de bague et la bague ayant un diamètre intérieur qui est supérieur aux longueurs de bord de la face frontale côté sortie (10).

21. Générateur de plasma selon l'une des revendications 18 à 20,
la charge passive (18) comportant un matériau isolant, en particulier de l'oxyde d'aluminium.

22. Générateur de plasma selon l'une des revendications 18 à 21,
le générateur de plasma comportant un boîtier (12) en un premier matériau dans lequel est disposé le transformateur piézoélectrique (1), et la charge passive (18) comportant un deuxième matériau, la constante diélectrique du deuxième matériau étant supérieure à la constante diélectrique du premier matériau.

23. Générateur de plasma selon l'une des revendications 18 à 20,
la charge passive (19) étant en un matériau électriquement conducteur ou en un matériau semiconducteur et un matériau isolant étant disposé entre la charge (19) et le transformateur piézoélectrique (1) .

24. Générateur de plasma selon l'une des revendications précédentes,
le transformateur piézoélectrique (1) étant conçu pour amorcer le plasma non thermique à pression atmosphérique sur sa face frontale côté sortie (10).
